# FASCICULE DE BREVET EUROPEEN

(11) **EP 1 463 391 B1**
(45) Date de publication et mention de la délivrance du brevet: **16.06.2010**
(21) Numéro de dépôt: 04290721.2
(22) Date de dépôt: 16.03.2004
(51) Int. Cl.: H05K 3/34, H05K 1/02, F21V 19/00, F21S 8/10, H01L 33/00, B60Q 1/26

(54) **Procédé de fixation d'une diode électroluminescente de puissance sur un radiateur, et dispositif de signalisation comportant une telle diode**
Verfahren zur Befestigung einer Leistungsleuchtdiode an einem Kühlkörper und Signaleinrichtung mit solcher Leuchtdiode
Process for attaching a power LED to a heatsink and a signalling device comprising such a LED

(30) Priorité: 27.03.2003 FR 0303840
(43) Date de publication de la demande: 29.09.2004
(73) Titulaire: VALEO VISION, 93012 Bobigny Cedex (FR)
(72) Inventeur: Gasquet, Jean-Claude, 89100 Saint Clement (FR); Tanghe, Alcina, 77000 Melun (FR)

(56) Documents cités:
- EP-A- 1 139 019
- DE-A- 4 221 564
- DE-A- 10 117 889
- US-A- 4 023 005
- US-A1- 2001 030 866
- US-A1- 2002 067 621
- WHITEHEAD D G ET AL: "SOLDERING WITH LIGHTÜ" ASSEMBLY AUTOMATION, BRADFORD, GB, vol. 15, no. 2, 1995, pages 17-19, XP008003595

## Description

L'invention est relative à un procédé pour fixer une diode électroluminescente (LED) de puissance sur un élément radiateur métallique, généralement à base de cuivre.

Par l'expression « diode électroluminescente de puissance », on désigne une diode dont l'énergie thermique à dissiper exige une embase spécifique métallique, par exemple en cuivre, servant d'alimentation et/ou de radiateur.

On sait qu'une bonne dissipation thermique est nécessaire pour les diodes électroluminescentes, car leur rendement lumineux diminue si la température de jonction augmente. Une diode de puissance est ainsi généralement prévue avec un corps ou embase métallique, par exemple en cuivre, permettant d'établir un contact thermique efficace avec un élément radiateur pour la dissipation de la chaleur produite.

La fixation de la diode électroluminescente de puissance et son refroidissement constituent un problème à résoudre afin d'optimiser le rendement lumineux.

Pour la fixation, il faut tenir compte du fait qu'une diode électroluminescente est un composant électronique relativement fragile et sensible à la chaleur. Ainsi, pour éviter tout risque de détérioration de la diode électroluminescente, il a été proposé dans le document EP-A-1 387 870 au nom de la Demanderesse, ou dans le document EP -A-1 139 019, d'assurer la fixation de l'embase de la diode sur le radiateur par une colle conductrice thermique.

Ce procédé, tout en donnant satisfaction, complique la gamme de fixation par utilisation d'un composant supplémentaire, à savoir la colle, sensible aux conditions de stockage, exigeant des moyens de dépose spécifiques et, surtout, conduisant à un allongement du cycle de fabrication par un temps de réticulation relativement long. En outre, il faut prévoir des moyens de maintien temporaires de la diode sur son radiateur jusqu'à ce que la colle assure un maintien mécanique suffisant, c'est-à-dire au moins pendant toute la période de réticulation.

Il est connu également, du document US 2002/0067621 de souder au moyen d'un laser les extrémités des électrodes d'une LED sur les pistes métalliques d'un support, qui est par ailleurs constitué d'un matériau thermoplastique hautement résistant à la température. Selon ce document, la fixation mécanique des LEDs sur leur support est obtenue uniquement par la soudure de leurs électrodes sur les pistes du support, et simultanément à leur connexion électrique. Une telle conception a pour but de fixer des LEDs sur un support sans les soumettre à une chaleur excessive qui pourrait les endommager, voire les détruire.

L'invention a pour but, surtout, de fournir un procédé de fixation de la diode électroluminescente sur l'élément radiateur qui permette de réduire la durée du cycle de fabrication, de simplifier les moyens de fabrication, d'assurer une répétitivité du processus de liaison de la diode sur son radiateur, tout en évitant une dégradation de cette diode.

Selon l'invention, le procédé de fixation de la diode électroluminescente de puissance ayant une embase métallique, sur un élément métallique radiateur de chaleur, est caractérisé par le fait que l'embase de la diode électroluminescente est fixée sur l'élément radiateur par soudure laser par points.

De préférence, on utilise un élément radiateur revêtu d'une couche d'un métal, en particulier de nickel, propre à absorber l'énergie d'une lumière laser.

La Demanderesse a pu constater qu'une soudure laser par points de l'embase n'entraînait pas de dégradation de la diode électroluminescente. La présence d'une couche de métal absorbant la lumière laser sur le radiateur contribue à l'établissement d'une soudure efficace.

Avantageusement, on réalise les points de soudure sensiblement suivant un contour fermé, notamment circulaire, de préférence au voisinage du périmètre extérieur de l'embase.

L'invention est également relative à un dispositif de signalisation ou d'éclairage pour automobile comprenant une diode électroluminescente de puissance dont l'embase métallique, est fixée sur un élément métallique radiateur de chaleur, ce dispositif étant caractérisé par le fait que l'embase de la diode est fixée par soudure laser par points sur l'élément radiateur.

De préférence l'élément radiateur est recouvert d'une couche d'un métal absorbant le rayonnement laser, en particulier une couche de nickel.

Les centres des points de soudure sont répartis sensiblement régulièrement sur un contour parallèle au périmètre extérieur de l'embase, notamment circulaire. Ce contour est de préférence voisin du périmètre extérieur de l'embase.

Avantageusement, des moyens de centrage du corps de la diode sont prévus sur l'élément radiateur de chaleur. Ces moyens de centrage peuvent comprendre des saillies réalisées dans l'élément radiateur.

Les électrodes de la diode peuvent également être soudées au laser par points à des pattes conductrices.

Selon une première possibilité, l'élément radiateur de chaleur, sur lequel est fixée l'embase de la diode électroluminescente, est rapporté sur un support isolant qui est situé du côté opposé à la diode par rapport à l'élément radiateur, ce support isolant comportant des pattes de raccordement électrique, chaque électrode de la diode étant reliée respectivement à une patte, ledit support isolant comportant des ouvertures au droit de l'embase et des électrodes de la diode pour le passage du faisceau laser de soudure.

Selon une deuxième possibilité, l'élément radiateur de chaleur est un circuit métallique prédécoupé, par exemple en cuivre, dont les différents conducteurs sont reliés entre eux par des liaisons minces, appelées shunts.

Sur ce circuit est surmoulée une matière plastique isolante électriquement, faisant office de support isolant, la matière plastique surmoulée comportant des ouvertures au droit de l'emplacement de l'embase et des électrodes de la diode pour le passage du faisceau laser de soudure.

Pendant cette opération, les shunts sont découpés par un mécanisme intégré au moule, de sorte que les différents conducteurs sont électriquement séparés les uns des autres.

Les pattes de la diode peuvent alors être soudées sur ces conducteurs au laser, comme précédemment.

Les pattes de raccordement peuvent être situées du côté du support isolant tourné vers l'élément radiateur.

Selon une variante, les pattes de raccordement sont situées du côté du support isolant opposé à l'élément radiateur de chaleur et la liaison entre chaque patte de raccordement et l'électrode correspondante de la diode s'effectue à travers une fenêtre prévue dans le support isolant et une autre fenêtre prévue dans l'élément radiateur.

Selon une autre disposition, le support isolant est situé du côté de la diode par rapport au radiateur de chaleur ; une ouverture est prévue dans le support isolant au droit de l'embase de la diode électroluminescente pour son logement et sa venue au contact du radiateur, des ouvertures étant prévues également pour les électrodes.

L'invention consiste, mises à part les dispositions exposées ci-dessus, en un certain nombre d'autres dispositions dont il sera plus explicitement question ci-après à propos d'exemples de réalisation décrits avec référence aux dessins annexés, mais qui ne sont nullement limitatifs.

Sur ces dessins :
Fig.1 est une coupe schématique illustrant le procédé de fixation de la diode électroluminescente de puissance sur l'élément radiateur de chaleur.
Fig.2 est une section schématique suivant la ligne II-II de Fig.1 montrant une répartition de points de soudure.
Fig.3 est une vue en perspective, à plus petite échelle, d'un ensemble de signalisation avec support isolant, radiateur de chaleur et diode fixée sur le radiateur.
Fig.4 est une vue en perspective d'une variante de réalisation de l'ensemble de Fig.3.
Fig.5 est une vue en perspective du dessous de l'ensemble de Fig.4.
Fig.6 est une vue en perspective éclatée, à plus petite échelle, de l'ensemble de Fig.4 avant assemblage.
Fig.7 est une vue de dessus, à plus grande échelle, d'une variante de réalisation de l'ensemble de Fig.4.
Fig.8 est une vue en perspective d'une variante de réalisation de l'élément radiateur de chaleur.
Fig.9 est un schéma en perspective avec partie arrachée, illustrant un moyen de positionnement de la diode électroluminescente sur l'élément radiateur, et
Figs. 10 à 12 montrent, semblablement à Fig.2, d'autres répartitions de points de soudure.

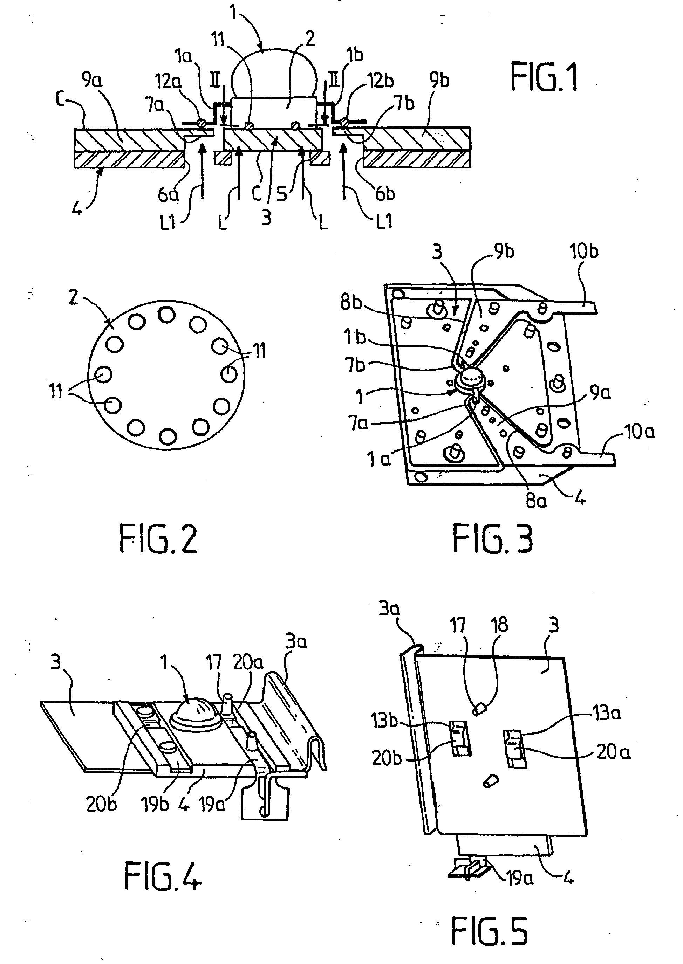

En se reportant aux dessins, notamment à Fig.1, on peut voir une diode électroluminescente de puissance 1, c'est-à-dire une diode dont l'énergie thermique à dissiper exige une embase spécifique en cuivre servant d'alimentation et/ou de radiateur, pouvant par exemple fournir un flux lumineux d'au moins 30 lumens et de préférence de 40 lumens ou plus, qui comporte une embase 2, ou corps, principalement en cuivre pour permettre une bonne dissipation de la chaleur produite par la diode. Cette embase 2 est généralement désignée par le terme "slug". La diode 1 comporte deux électrodes 1a, 1b généralement formées par des lamelles de cuivre.

La diode 1 est disposée sur un élément radiateur de chaleur 3 lequel est lui-même fixé sur un support isolant 4 formé par une plaque rigide en matière plastique isolante électriquement. Le support 4 peut être plan, ou présenter une surface courbe, ou une surface étagée. Le support 4 isolant constitue, par exemple, une base en matière plastique correspondant à un dispositif porte-source d'éclairage d'un feu de signalisation.

L'élément radiateur 3 est constitué par une plaque de cuivre recouverte au moins sur sa face adjacente à l'embase 2, et de préférence sur ses deux faces, par une couche C d'un métal propre à absorber l'énergie d'une lumière laser. La couche C est de préférence une couche de nickel, et son épaisseur est de quelques micromètres.

Dans le support isolant 4, au-dessous de l'embase 2, est prévue une ouverture 5 ayant sensiblement la même forme et la même section que l'embase 2. Deux autres ouvertures 6a, 6b sont prévues dans le support 4 au-dessous des électrodes 1a, 1b. L'épaisseur du support 3 à l'aplomb des ouvertures 6a, 6b peut être réduite de sorte que des lames 7a, 7b sont formées sous les électrodes 1a, 1b.

Comme visible sur Fig.3, l'élément radiateur de chaleur 3 comporte deux échancrures opposées 8a, 8b en direction de la zone de fixation de la diode électroluminescente 1 et correspondant aux électrodes 1a, 1b. Dans chaque échancrure une patte en forme de languette 9a, 9b, découpée dans l'élément radiateur 3, est raccordée par son extrémité 7a, 7b voisine de la diode 1 à une électrode associée 1a, 1b. Les bords de chaque patte 9a, 9b sont distants de ceux de l'échancrure correspondante de sorte que les pattes 9a, 9b sont isolées électriquement de la partie restante de l'élément radiateur 3. Les pattes 9a, 9b sont reliées électriquement à d'autres pattes 10a, 10b, généralement de forme rectangulaire pour le raccordement électrique. Selon Fig.3, les pattes 10a, 10b forment une seule et même pièce avec les pattes 9a, 9b. En variante, ces pattes peuvent être constituées par deux pièces différentes.

La fixation de l'élément radiateur 3 et des pattes 9a, 9b sur le support isolant 4 est assurée à l'aide de picots en saillie sur l'élément 4 en matière plastique traversant des trous prévus dans le radiateur 3 et les pattes 9b, comme visible sur Fig.3.

L'embase 2 de la diode est fixée sur l'élément radiateur 3 par soudure laser par points. Sur Fig.1, le faisceau laser utilisé pour la fixation de l'embase 2 est schématisé par des flèches L. Les points de soudure 11 entre l'embase 2 de diode et l'élément radiateur 3 correspondent aux points d'impact des rayons lasers. Les centres des points de soudure successifs 11 peuvent être répartis sensiblement régulièrement sur un contour parallèle au périmètre extérieur de l'embase, notamment circulaire, comme illustré sur Fig.2. Ce contour est de préférence voisin du périmètre extérieur de l'embase 2, ce qui réduit l'influence thermique sur la jonction de la diode.

Selon une deuxième possibilité, l'élément radiateur de chaleur est un circuit métallique prédécoupé, par exemple en cuivre, dont les différents conducteurs sont reliés entre eux par des liaisons minces, appelées shunts.

Sur ce circuit est surmoulée une matière plastique isolante électriquement, faisant office de support isolant, la matière plastique surmoulée comportant des ouvertures au droit de l'emplacement de l'embase et des électrodes de la diode pour le passage du faisceau laser de soudure.

Pendant cette opération, les shunts sont découpés par un mécanisme intégré au moule, de sorte que les différents conducteurs sont électriquement séparés les uns des autres.

Les pattes de la diode peuvent alors être soudées sur ces conducteurs au laser, comme précédemment.

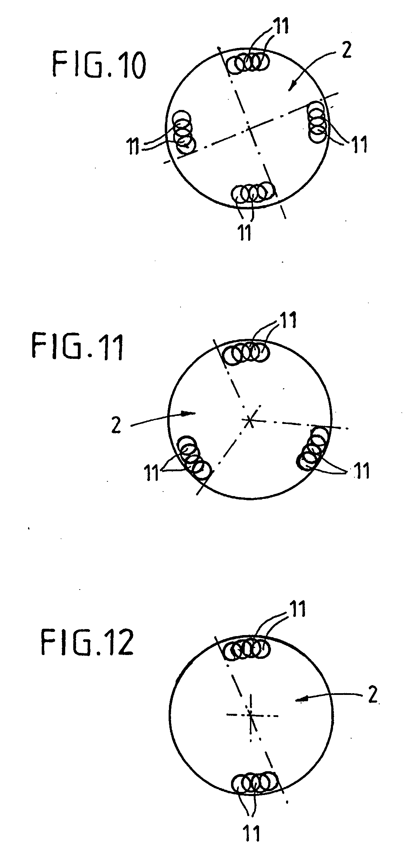

Figs. 10 à 12 montrent des variantes possibles de répartition de points de soudure 11 se recouvrant en partie. Selon Fig.10, quatre groupes de quatre points de soudure 11 sont distants angulairement de 90° sur une même circonférence. Dans chaque groupe, le périmètre d'un point de soudure suivant passe sensiblement par le centre du point de soudure précédent. Fig. 11 montre trois groupes de quatre points de soudure 11 distants angulairement de 120°, et Fig.12 montre deux groupes de quatre points de soudure 11 diamétralement opposés.

Quel que soit le type de répartition, les points de soudure 11 sont de préférence quasiment tangents intérieurement au périmètre extérieur de l'embase.

Le laser utilisé est un laser à impulsions procédant par tirs successifs. La puissance des tirs et le nombre de tirs pour un point de soudure 11 sont choisis pour assurer une résistance optimale sans créer une élévation de température de l'embase 2 susceptible de dégrader la jonction de la diode.

L'énergie du faisceau laser est bien absorbée par la couche de nickel C ce qui permet d'obtenir des points de soudure 11 de bonne qualité.

La fixation des électrodes 1a, 1b sur les lames 7a, 7b est également réalisée avantageusement par soudure par points au faisceau laser. Les flèches L1, sur Fig.1, schématisent les rayons lasers utilisés pour la soudure des électrodes. Ces rayons traversent les ouvertures 6a, 6b ; leurs points d'impact déterminent les points de soudure 12a, 12b à l'interface des électrodes 1a, 1b et des lames 7a, 7b.

D'une manière générale, pour obtenir de bonnes soudures, on s'efforce de rendre les épaisseurs des pièces soudées aussi voisines que possible. Dans l'exemple considéré, les lames 7a, 7b ont une épaisseur réduite par rapport à celle du radiateur 3 car les électrodes 1a, 1b ont elles-mêmes une épaisseur réduite par rapport à l'embase 2.

Le procédé de l'invention permet de réaliser une fixation par soudure "autogène" entre l'élément radiateur 3, réalisé en cuivre enrobé d'une couche C de nickel, et l'embase 2. Ce procédé permet de réaliser d'une part la fixation physique de la diode 1 sur son support radiateur 3 et, d'autre part, son branchement électrique par liaison des électrodes 1a, 1b avec les pattes 9a, 9b. La durée du cycle de fabrication est fortement réduite et les moyens de fabrication sont simplifiés puisqu'un seul procédé de fixation par soudure laser par points est utilisé. La soudure laser permet d'assurer une répétitivité du processus de liaison de la diode par maîtrise des paramètres de pilotage.

La diode électroluminescente 1 est généralement utilisée comme source lumineuse dans un ensemble optique plus complexe intégrant divers éléments tels que réflecteur, lentille. Dans tout système optique, la position spatiale de la source est très importante.

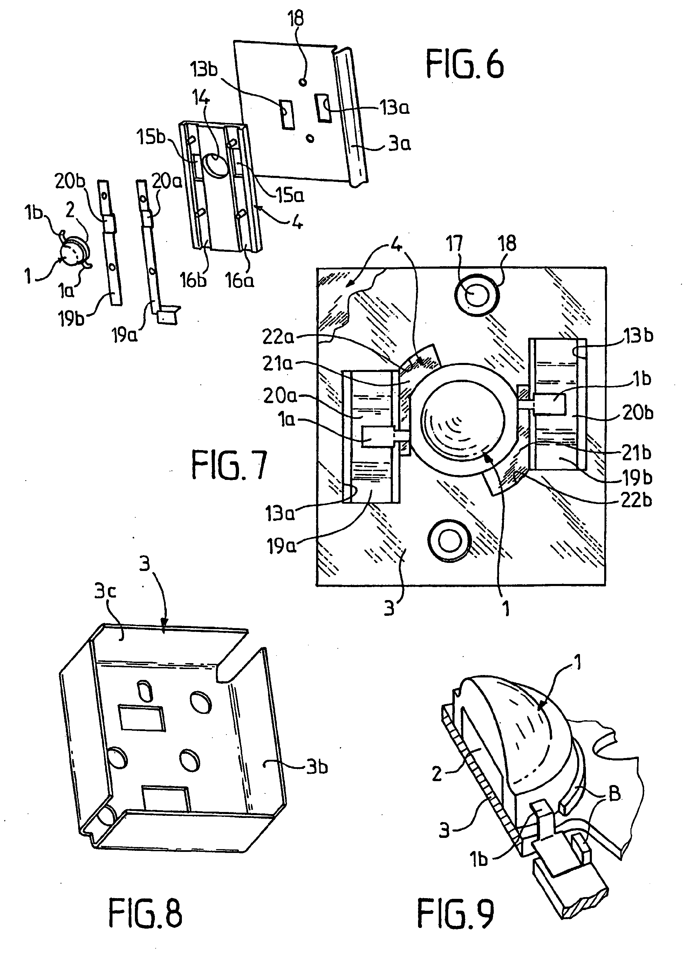

Pour assurer le positionnement géométrique correct de la diode 1 sur l'élément radiateur 3, on peut prévoir une assistance au positionnement de la diode 1 sur la surface du radiateur 3 comme illustré sur Fig.9. Pour cela, on utilise les propriétés ductiles spécifiques du cuivre, et on réalise, lors de la création du radiateur 3, via un outil de découpe, un moyen de centrage physique par exemple sous forme d'une ou plusieurs saillies B, en surface du radiateur 3, propres à coopérer avec le contour de la diode 1 et des électrodes pour le positionnement. Les saillies B peuvent être continues ou discontinues et peuvent être prévues pour un contour de diode de forme quelconque, circulaire, rectangulaire ou autre.

Ce moyen d'assistance au positionnement est particulièrement intéressant pour des machines automatiques de mise en place de la diode 1 sur son élément radiateur 3.

Il est à noter également que la fixation de l'embase 2 sur l'élément radiateur 3 est quasiment immédiate et qu'il n'est pas nécessaire, comme dans le cas où l'embase est fixée par une colle sur le radiateur 3, d'assurer un maintien mécanique temporaire de la diode 1 relativement au radiateur 3 par les électrodes 1a, 1b et les pattes 9a, 9b pendant le temps nécessaire à la réticulation de la colle. Ainsi, les pattes 9a, 9b peuvent être rendues immédiatement indépendantes du reste de l'élément radiateur 3.

La réalisation du cycle de fixation de la diode 1 sur son support est la suivante.

La diode 1 est positionnée sur l'élément radiateur 3, les électrodes 1a, 1b étant maintenues en contact avec les languettes 9a, 9b, tandis que l'embase 2 est maintenue en contact avec le radiateur 3.

Les points de soudure 11 et 12a, 12b sont réalisés dans un seul cycle obtenu par pilotage d'un laser via un programme informatique géré par ordinateur. Le faisceau laser est dirigé par un système de deux miroirs internes connus sous le terme de tête « scan ».

Tous les paramètres correspondants aux conditions de tir (impulsion laser) sont également gérés par ordinateur assurant ainsi une grande qualité de soudure autogène.

La durée d'un tir est de quelques millisecondes, la fréquence des tirs de quelques hertz (Hz). L'opération de soudure complète est réalisée avec un nombre de tirs variant de quelques unités à plusieurs dizaines selon la résistance à l'arrachement exigé.

Le cycle complet de fixation pour une diode est de quelques dizaines de secondes.

En se reportant aux Fig.4 à 6, on peut voir une variante de réalisation selon laquelle le support isolant 4 est situé du même côté que la diode 1 par rapport à l'élément radiateur 3, alors que selon Fig.1, le support isolant 4 était situé du côté opposé à la diode 1 par rapport au radiateur 3.

L'élément radiateur 3 est toujours constitué d'une plaque de cuivre enrobée d'une couche de nickel, mais la surface utile du radiateur 3 est maximale, car les pattes 9a, 9b de Fig.3 ont disparu. Le radiateur 3 peut présenter sur l'un de ses bords un repli 3a pour servir à la fixation et augmenter la surface d'échange thermique. Le radiateur 3 comporte deux fenêtres rectangulaires 13a, 13b constituant des ouvertures correspondant aux électrodes 1a, 1b de la diode 1.

Le support isolant 4 comporte une ouverture 14 pour le logement de la diode 1 et, de part et d'autre de cette ouverture, deux fenêtres rectangulaires 15a, 15b en correspondance avec les électrodes. Deux rainures parallèles 16a, 16b sont prévues dans la face du support isolant 4 opposé au radiateur 3. Ces rainures sont parallèles à une des directions des côtés du support isolant 4 rectangulaire, par exemple parallèle à la direction des grands côtés. La fixation du radiateur 3 sur le support 4 est assurée à l'aide de picots 17 en saillie sur la face du support 4 en regard du radiateur 3, coopérant avec des trous 18 prévus dans le radiateur 3. Les rainures 16a, 16b sont tangentes à l'ouverture 14 par leurs bords internes. Les fenêtres 15a, 15b s'ouvrent dans le fond des rainures 16a, 16b.

Deux lames ou pattes 19a, 19b, en matériau conducteur de l'électricité, par exemple en cuivre, de forme rectangulaire, sont prévues pour venir s'inscrire et être fixées dans les rainures 16a, 16b. La fixation des lames 19a, 19b est réalisée par coopération de picots prévus en saillie dans le fond des rainures 16a, 16b et de trous correspondants prévus dans les lames 19a, 19b. Chaque lame 19a, 19b comporte une partie 20a, 20b déformée hors du plan de la lame et constituant une sorte de pont en saillie d'un côté de la lame. Cette partie 20a, 20b de chaque lame est prévue pour venir se loger dans la fenêtre correspondante 15a, 15b du support isolant 4 et dans la fenêtre correspondante 13a, 13b du radiateur 3. Les lames 19a, 19b sont disposées de telle sorte que les parties 20a, 20b fassent saillie en direction du radiateur 3 à travers les fenêtres 15a, 15b. Le support isolant 4 maintient les lames 19a et 19b de telle manière que les saillies 20a, 20b restent écartées des bords des ouvertures 13a, 13b et donc isolées électriquement du radiateur 3.

Les zones creuses concaves des parties 20a, 20b sont ouvertes du côté opposé au radiateur 3 et reçoivent les électrodes 1a, 1b.

La fixation de l'embase de la diode 1 sur le radiateur 3 est réalisée en dirigeant les tirs de faisceau laser contre la face du radiateur 3 opposée au support isolant 4, dans la zone située contre l'embase 2.

La soudure par points des électrodes 1a, 1b est assurée en dirigeant les tirs de faisceau laser contre les parties 20a, 20b des pattes 19a, 19b qui apparaissent à travers les ouvertures 13a, 13b du côté opposé au support isolant 4.

Le raccordement électrique de la diode 1 au circuit associé est assuré par le raccordement aux pattes 19a, 19b.

Fig.7 illustre une autre variante de réalisation selon laquelle, le support isolant 4 est situé, comme sur Fig.3, du côté du radiateur 3 opposé à la diode 1. A la différence de Fig.3, selon Fig.7 les lames ou pattes 19a, 19b de raccordement électrique des électrodes 1a, 1b sont disposées du côté du support isolant 4 opposé au radiateur 3.

Une vue en perspective éclatée de l'assemblage de Fig.7 correspondrait sensiblement à la représentation de Fig.6 mais la diode 1 se trouverait du côté du radiateur 3 opposé au support 4.

Selon Fig.7, l'embase de la diode 1 est en contact direct avec la zone pleine du radiateur 3 comprise entre les fenêtres 13a, 13b, du côté opposé au support 4, lequel comporte une ouverture 14, comme sur Fig.6, au droit de l'embase de la diode pour permettre le passage du faisceau laser.

La fixation du radiateur 3 sur le support isolant 4 est assurée par des picots 17 en matière plastique traversant des trous 18 prévus dans le radiateur, et écrasés pour bloquer la fixation.

Le positionnement géométrique correct du radiateur 3 sur le support isolant 4 est avantageusement assuré à l'aide de parties en saillie 21a, 21b prévues sur le support isolant 4 pour coopérer avec des échancrures correspondantes 22a, 22b prévues dans le radiateur 3. Les zones convexes des parties 20a, 20b des lames 19a, 19b apparaissent à travers les ouvertures 13a, 13b sensiblement à fleur de la surface du radiateur 3. Les électrodes 1a, 1b viennent s'appliquer sur la surface supérieure des parties 20a, 20b.

La fixation par soudure laser par points s'effectue depuis l'arrière, par rapport à Fig.7, à travers l'ouverture 14 du support isolant 4 pour la fixation de l'embase de la diode 1, et à travers les ouvertures 15a, 15b du support 4 pour la soudure par points des électrodes 1a, 1b.

La surface des ouvertures 13a, 13b ménagée dans le radiateur 3 est réduite par rapport à celle des échancrures de Fig.3 entourant les languettes 9a, 9b. La surface du radiateur 3 assurant les échanges thermiques selon les réalisations des Figs.4 à 7 est donc plus importante et permet une meilleure dissipation thermique.

Fig.8 illustre une variante de réalisation de l'élément radiateur 3, qui comporte, sur ses bords, des parties relevées à angle droit 3b, 3c constituant des ailettes favorisant la dissipation thermique sous un encombrement réduit et permettant ainsi d'optimiser le rapport encombrement/effet radiatif.

Le cycle de fixation de la diode 1 sur le radiateur selon les variantes des Figs.4 à 6 et Fig.7 se déduit des explications qui précèdent.

Une première étape consiste à fixer les lames 20a, 20b sur le support isolant 4 par coopération des picots prévus sur ce support et des trous prévus dans les lames.

Le radiateur 3 est ensuite fixé sur le support isolant 4 également par coopération de picots et de trous.

La diode électroluminescente 1 est ensuite positionnée sur le radiateur 3, soit du côté du support isolant 4 avec mise en place de l'embase 2 dans l'ouverture 14 (Figs.4 à 6), soit du côté opposé au support isolant 4 (Fig.7). On assure le contact de l'embase de la diode 1 avec le radiateur 3 et des électrodes 1a, 1b avec les parties 20a, 20b. On lance ensuite l'opération de soudure par rayon laser.

L'invention permet d'avoir une gamme de production restreinte dans l'espace et dans le temps. Elle supprime les opérations liées à l'utilisation d'une colle comme fixateur et le cycle de cuisson obligatoire.

L'invention favorise l'environnement du poste de travail en supprimant tout traitement de surface spécifique ou tout composant agressif lié à un processus de collage.

## Revendications

1. Procédé de fixation d'une diode électroluminescente de puissance (1) ayant une embase (2) métallique sur un élément métallique radiateur de chaleur (3), **caractérisé par le fait que** l'embase (2) de la diode électroluminescente est fixée sur l'élément radiateur (3) par soudure laser par points (11).

2. Procédé selon la revendication 1, **caractérisé par le fait que** l'élément radiateur (3) est revêtu d'une couche (C) d'un métal, propre à absorber l'énergie d'une lumière laser.

3. Procédé selon la revendication 1 ou 2, **caractérisé par le fait que** les centres des points de soudure (11) sont répartis régulièrement sur un contour parallèle au périmètre extérieur de l'embase.

4. Procédé selon la revendication 3, **caractérisé par le fait que** les points de soudure (11) sont réalisés au voisinage du périmètre extérieur de l'embase (2).

5. Dispositif de signalisation ou d'éclairage pour automobile comprenant une diode électroluminescente de puissance dont l'embase est fixée sur un élément métallique radiateur de chaleur, **caractérisé par le fait que** l'embase (2) de la diode est fixée par soudure laser par points (11) sur l'élément radiateur (3).

6. Dispositif selon la revendication 5, **caractérisé par le fait que** l'élément radiateur (3) est recouvert d'une couche (C) d'un métal absorbant le rayonnement laser.

7. Dispositif selon la revendication 5 ou 6, **caractérisé par le fait que** les centres des points de soudure (11) sont répartis régulièrement sur un contour parallèle au périmètre extérieur de l'embase.

8. Dispositif selon la revendication 7, **caractérisé par le fait que** les points de soudure (11) sont répartis au voisinage du périmètre extérieur de l'embase (2).

9. Dispositif selon l'une des revendications 5 à 8, **caractérisé par le fait que** des moyens de centrage (B) de l'embase (2) de la diode sont prévus sur l'élément (3) radiateur de chaleur et comprennent des saillies réalisées dans l'élément radiateur (3).

10. Dispositif selon l'une des revendications 5 à 9, **caractérisé par le fait que** les électrodes (1a, 1b) de la diode sont soudées au laser par points à des pattes conductrices.

11. Dispositif selon l'une des revendications 5 à 10, **caractérisé par le fait que** l'élément (3) radiateur de chaleur, sur lequel est fixée l'embase (2) de la diode électroluminescente, est rapporté sur un support isolant (4) situé du côté opposé à la diode par rapport à l'élément radiateur, ce support isolant (4) comportant des pattes (9a, 9b ; 19a, 19b) de raccordement électrique, chaque électrode (1a, 1b) de la diode étant reliée respectivement à une patte, ledit support isolant (4) comportant des ouvertures (5 ; 14) au droit de l'embase et des ouvertures ( 6a, 6b ; 15a, 15b) au droit des électrodes de la diode pour le passage du faisceau laser de soudure.

12. Dispositif selon la revendication 11, **caractérisé par le fait que** les pattes de raccordement (9a, 9b) sont situées du côté du support isolant (4) tourné vers l'élément radiateur (3).

13. Dispositif selon la revendication 11, **caractérisé par le fait que** les pattes de raccordement (15a, 15b) sont situées du côté du support isolant (4) opposé à l'élément radiateur (3) de chaleur et la liaison entre chaque patte de raccordement et l'électrode correspondante de la diode s'effectue à travers une fenêtre (15a, 15b) prévue dans le support isolant (4) et une autre fenêtre (13a, 13b) prévue dans l'élément radiateur.

14. Dispositif selon l'une revendications 5 à 10, **caractérisé par le fait que** l'élément (3) radiateur de chaleur, sur lequel est fixée l'embase (2) de la diode électroluminescente, est rapporté sur un support isolant (4) situé du côté de la diode (2) par rapport au radiateur de chaleur (3) , une ouverture (14) étant prévue dans le support isolant (4) au droit de l'embase (2) de la diode électroluminescente pour son logement et sa venue au contact du radiateur, des ouvertures (15a, 15b) étant prévues également pour les électrodes.

15. Dispositif selon l'une des revendications 5 à 10, **caractérisé en ce que** le support isolant (4) est surmoulé sur l'élément (3) radiateur de chaleur en ménageant des ouvertures au droit de l'emplacement de l'embase (2) de la diode électroluminescente et pour les électrodes.

16. Dispositif selon l'une quelconque des revendications 5 à 15, **caractérisé en ce que** l'embase (2) de la diode (1) est composée de cuivre.

17. Dispositif selon l'une quelconque des revendications 5 à 15, **caractérisé en ce que** le radiateur de chaleur (3) est composé de cuivre.

18. Dispositif selon l'une quelconque des revendications 5 à 15 et 17, **caractérisé en ce que** l'élément radiateur (3) est revêtu d'une couche (C) de nickel, propre à absorber l'énergie d'une lumière laser.

## Claims

1. Method of fixing a power light-emitting diode (1) having a metallic base (2) to a metallic heat-radiating element (3), **characterised by** the fact that the base (2) of the light-emitting diode is fixed to the radiating element (3) by laser spot welding (11).

2. Method according to Claim 1, **characterised by** the fact that the radiating element (3) is coated with a layer (C) of a metal, for example nickel, able to absorb the energy of a laser light.

3. Method according to Claim 1 or 2, **characterised by** the fact that the centres of the welding spots (11) are distributed regularly over a contour parallel to the external perimeter of the base.

4. Method according to Claim 3, **characterised by** the fact that the welding spots (11) are produced in the vicinity of the external perimeter of the base (2).

5. Indicating or lighting device for a car, comprising a power light-emitting diode whose base is fixed to a metallic heat-radiating element, **characterised by** the fact that the base (2) of the diode is fixed by laser spot welding (11) to the radiating element (3).

6. Device according to Claim 5, **characterised by** the fact that the radiating element (3) is covered with a layer (C) of a metal absorbing the laser radiation.

7. Device according to Claim 5 or 6, **characterised by** the fact that the centres of the welding spots (11) are distributed regularly over a contour parallel to the external perimeter of the base.

8. Device according to Claim 7, **characterised by** the fact that the welding spots (11) are distributed close to the external perimeter of the base (2).

9. Device according to one of Claims 5 to 8, **characterised by** the fact that the means (B) of centring the base (2) of the diode are provided on the heat-radiating element (3) and comprise projections produced in the radiating element (3).

10. Device according to one of Claims 5 to 9, **characterised by** the fact that the electrodes (1a, 1b) of the diode are laser spot welded to conductive lugs.

11. Device according to one of Claims 5 to 10, **characterised by** the fact that the heat-radiating element (3) to which the base (2) of the light-emitting diode is fixed is attached to an insulating support (4) situated on the opposite side to the diode with respect to the radiating element, this insulating support (4) comprising electrical connection lugs (9a, 9a; 19a, 19b), each electrode (1a, 1b) of the diode being connected respectively to a lug, the said insulating support (4) comprising openings (5; 14) in line with the base and openings (6a, 6b; 15a, 15b) in line with the electrodes of the diode for passage of the laser welding beam.

12. Device according to Claim 11, **characterised by** the fact that the connecting lugs (9a, 9b) are situated on the side of the insulating support (4) turned towards the radiating element (3).

13. Device according to Claim 11, **characterised by** the fact that the connecting lugs (15a, 15b) are situated on the side of the insulating support (4) opposite to the heat radiating element (3) and the connection between each connecting lug and the corresponding electrode of the diode is effected through a window (15a, 15b) provided in the insulating support (4) and another window (13a, 13b) provided in the radiating element.

14. Device according to one of Claims 5 to 10, **characterised by** the fact that the heat-radiating element (3) to which the base (2) of the light-emitting diode is fixed is attached to an insulating support (4) situated on the same side as the diode (2) with the respect to the heat radiator (3), an opening (14) being provided in the insulating support (4) in line with the base (2) of the light-emitting diode for its housing and its coming into contact with the radiator, openings (15a, 15b) being provided also for the electrodes.

15. Device according to one of Claims 5 to 10, **characterised in that** the insulating support (4) is moulded onto the heat-radiating element (3), providing openings in line with the location of the base (2) of the light-emitting diode and for the electrodes.

16. Device according to any one of Claims 5 to 15, **characterised in that** the base (2) of the diode (1) is principally composed of copper.

17. Device according to any one of Claims 5 to 15, **characterised in that** the heat radiator (3) is composed of copper.

18. Device according to any one of Claims 5 to 15 and 17, **characterised in that** the radiating element (3) is coated with a layer (C) of nickel, able to absorb the energy of a laser light.

## Patentansprüche

1. Verfahren zur Befestigung einer Leistungsleuchtdiode (1) mit einem Metallsockel (2) auf einem metallischen Kühlkörper (3),
**dadurch gekennzeichnet, dass** der Sockel (2) der Leuchtdiode auf dem Kühlkörper (3) durch Laserpunktschweißen (11) befestigt ist.

2. Verfahren nach Anspruch 1,
**dadurch gekennzeichnet, dass** der Kühlkörper (3) mit einer Schicht (C) aus einem Metall überzogen ist, das die Energie eines Laserlichts zu absorbieren vermag.

3. Verfahren nach Anspruch 1 oder 2,
**dadurch gekennzeichnet, dass** die Mittelpunkte der Schweißpunkte (11) auf einer Umrisslinie parallel zum Außenumfang des Sockels gleichmäßig verteilt sind.

4. Verfahren nach Anspruch 3,
**dadurch gekennzeichnet, dass** die Schweißpunkte (11) in der Nähe des Außenumfangs des Sockels (2) ausgeführt sind.

5. Kraftfahrzeugsignalgebungs- oder -beleuchtungsvorrichtung mit einer Leistungsleuchtdiode, deren Sockel auf einem metallischen Kühlkörper befestigt ist,
**dadurch gekennzeichnet, dass** der Sockel (2) der Diode durch Laserpunktschweißen (11) auf dem Kühlkörper (3) befestigt ist.

6. Vorrichtung nach Anspruch 5,
**dadurch gekennzeichnet, dass** der Kühlkörper (3) mit einer Schicht (C) aus einem die Laserstrahlung absorbierenden Metall überzogen ist.

7. Vorrichtung nach einem Anspruch 5 oder 6,
**dadurch gekennzeichnet, dass** die Mittelpunkte der Schweißpunkte (11) auf einer Umrisslinie parallel zum Außenumfang des Sockels gleichmäßig verteilt sind.

8. Vorrichtung nach Anspruch 7,
**dadurch gekennzeichnet, dass** die Schweißpunkte (11) in der Nähe des Außenumfangs des Sockels (2) verteilt sind.

9. Vorrichtung nach einem der Ansprüche 5 bis 8,
**dadurch gekennzeichnet, dass** Mittel (B) zum Zentrieren des Sockels (2) der Diode auf dem Kühlkörper (3) vorgesehen sind und am Kühlkörper (3) ausgeführte Vorsprünge aufweisen.

10. Vorrichtung nach einem der Ansprüche 5 bis 9,
**dadurch gekennzeichnet, dass** die Elektroden (1a, 1b) der Diode durch Laserpunktschweißen an leitende Laschen geschweißt sind.

11. Vorrichtung nach einem der Ansprüche 5 bis 10,
**dadurch gekennzeichnet, dass** der Kühlkörper (3), auf dem der Sockel (2) der Leuchtdiode befestigt ist, auf einen Isolierträger (4) aufgesetzt ist, der bezüglich des Kühlkörpers auf der der Diode abgewandten Seite angeordnet ist, wobei der Isolierträger (4) Laschen (9a, 9b; 19a, 19b) zum elektrischen Anschluss aufweist, wobei jede Elektrode (1a, 1b) der Diode jeweils mit einer Lasche verbunden ist, wobei der Isolierträger (4) Öffnungen (5; 14) rechtwinklig zum Sockel und Öffnungen (6a, 6b; 15a, 15b) rechtwinklig zu den Elektroden der Diode zum Hindurchführen des Laserschweißstrahls aufweist.

12. Vorrichtung nach Anspruch 11,
**dadurch gekennzeichnet, dass** die Anschlusslaschen (9a, 9b) auf der zum Kühlkörper gewandten Seite des Isolierträgers (4) angeordnet sind.

13. Vorrichtung nach Anspruch 11,
**dadurch gekennzeichnet, dass** die Anschlusslaschen (9a, 9b) auf der dem Kühlkörper (3) abgewandten Seite des Isolierträgers (4) angeordnet sind und die Verbindung zwischen jeder Anschlusslasche und der entsprechenden Elektrode der Diode über ein im Isolierträger (4) vorgesehenes Fenster (15a, 15b) und ein weiteres im Kühlkörper vorgesehenes Fenster (13a, 13b) erfolgt.

14. Vorrichtung nach einem der Ansprüche 5 bis 10,
**dadurch gekennzeichnet, dass** der Kühlkörper (3), auf dem der Sockel (2) der Leuchtdiode befestigt ist, auf einen Isolierträger (4) aufgesetzt ist, der bezüglich des Kühlkörpers (3) auf der Seite der Diode (1) angeordnet ist, wobei eine Öffnung (14) im Isolierträger (4) rechtwinklig zum Sockel (2) der Leuchtdiode vorgesehen ist, um diesen aufzunehmen und mit dem Kühlkörper in Kontakt zu bringen, wobei auch für die Elektroden Öffnungen (15a, 15b) vorgesehen sind.

15. Vorrichtung nach einem der Ansprüche 5 bis 10,
**dadurch gekennzeichnet, dass** der Isolierträger (4) auf den Kühlkörper (3) aufgespritzt ist, wobei Öffnungen rechtwinklig zur Lage des Sockels (2) der Leuchtdiode und für die Elektroden ausgespart sind.

16. Vorrichtung nach einem der Ansprüche 5 bis 15,
**dadurch gekennzeichnet, dass** der Sockel (2) der Diode (1) aus Kupfer besteht.

17. Vorrichtung nach einem der Ansprüche 5 bis 15,
**dadurch gekennzeichnet, dass** der Kühlkörper (3) aus Kupfer besteht.

18. Vorrichtung nach einem der Ansprüche 5 bis 15 und 17,
**dadurch gekennzeichnet, dass** der Kühlkörper (3) mit einer Nickelschicht (C) überzogen ist, die die Energie eines Laserlichts zu absorbieren vermag.
